# EUROPEAN PATENT SPECIFICATION

(11) **EP 3 088 829 B1**
(45) Date of publication and mention of the grant of the patent: **08.04.2020**
(21) Application number: 14873624.2
(22) Date of filing: 22.12.2014
(51) Int. Cl.: F28D 15/02, H01L 23/427, H05K 7/20, F28F 1/30

(54) **HEAT RECEIVING STRUCTURE AND HEAT SINK**
WÄRMEAUFNAHMESTRUKTUR UND KÜHLKÖRPER
STRUCTURE DE RÉCEPTION DE CHALEUR ET DISSIPATEUR THERMIQUE

(30) Priority: 24.12.2013 JP 2013266120
(43) Date of publication of application: 02.11.2016
(73) Proprietor: Furukawa Electric Co., Ltd., Chiyoda-ku Tokyo 100-8322 (JP)
(72) Inventor: HIRASAWA, Takeshi, Tokyo 100-8322 (JP); SASAKI, Chiyoshi, Tokyo 100-8322 (JP); IKEDA, Masami, Tokyo 100-8322 (JP)
(74) Representative: Forstmeyer, Dietmar
(86) International application number: PCT/JP2014/083884
(87) International publication number: WO 2015/098824

(56) References cited:
- JP-A- H0 346 355
- JP-A- H06 185 883
- JP-A- H11 281 270
- JP-A- 2000 216 313
- JP-A- 2001 044 347
- JP-A- 2006 220 340
- JP-A- 2006 308 239
- JP-U- S60 122 679
- TW-U- M 449 938
- US-A- 4 120 019
- US-A- 5 331 510
- US-A1- 2007 058 347
- US-A1- 2008 121 371

## Description

### Technical Field

The present invention relates to a structure of a heat receiving section of a heat sink.

### Background Art

The heat receiving section of a conventional heat pipe and heat sink is configured by inserting heat pipes into holes formed in a heat receiving block (Patent Literature 1). The configuration is preferable in terms of performance because heat can be absorbed from all around the heat pipe. There is also proposed a structure configured by forming a heat receiving section into a plate, attaching a flat heat pipe to the heat receiving section, or further attaching blocks to side faces thereof (Patent Literature 2). Further, there is also proposed a structure configured by engraving a U-shaped groove in a heat receiving block, and disposing a heat pipe in the U-shaped groove (Patent Literature 3). A heat receiving structure according to the preamble of claim 1 is disclosed in document US 2007/0058347 A1.

### Citation List

### Patent Literature

Patent Literature 1: Japanese Patent Laid-Open No. 2000-332175
Patent Literature 2: Japanese Patent Laid-Open No. 2006-310739
Patent Literature 3: Japanese Patent Laid-Open No. 2005-241173

### Summary of Invention

### Technical Problem

However, Patent Literature 1 has many problems such as requiring high material cost since the block shape is adopted, increasing working cost of the block since the holes need to be formed, and a brazing and soldering material and a heat conductive adhesive used in fixing and thermal joining being squeezed out at a time of insertion of the heat pipes.

Further, in each of Patent Literature 2 and Patent Literature 3, a heat pipe is in contact with other heat receiving members only at a heat receiving face side, and a contact area is smaller as compared with Patent Literature 1, so that heat resistance is high, and performance is worsened. Further, there is the problem that when a force is applied in a direction to rip off the heat pipe, the heat pipe easily falls off from the heat receiving member, and the structure becomes low in strength. Further, according to the art of Patent Literature 3, there is the problem that the working time which is equivalent to or greater than the time required to form a hole is needed, and cost is increased.

Thus, an object of the present invention is to provide a heat receiving structure and a heat sink that can ensure a sufficient contact area between a heat pipe and a heat receiving member, and are high in strength.

### Solution to Problem

The present invention is a heat receiving structure in which a heat pipe is sandwiched by heat receiving members from both sides and joined, wherein at least the heat receiving member at one side includes a concave inner face that is along an external shape of the heat pipe, and extended portions that extend toward both sides of the inner face while covering the heat pipe.

In this configuration, the heat receiving member has the concave inner face along the external shape of the heat pipe, and therefore, a sufficient contact area can be ensured between the heat pipe and the heat receiving member.

Further, since the extended portions at both sides that continue to the inner face of the heat receiving member are in a form extending inward in the radial direction of the heat pipe while covering the heat pipe, heat obtained from the heat receiving face of the heat receiving member also can be inputted into the heat pipe from side faces, and heat performance is improved. Since the heat pipe has a structure held by the heat receiving members at both sides by attaching the heat receiving members at both sides to the heating section, the heat pipe can be fixed at low cost without using brazing and soldering with high working cost and an adhesive with low heat performance, and heat performance is enhanced.

Further, since the heat pipe is held by the extended portions, strength is increased with respect to ripping forces from the heat receiving face in the case of combined use with brazing and soldering, or the like. At the time of producing the heat receiving members, for example, a working method with low cost such as extruding and die casting can be used, and when the heat receiving members are produced by cutting work due to limitation of the material, only the shapes corresponding to the side face portions of the heat pipe have to be worked, so that a cutting work time can be reduced.

For example, when a heat receiving plate is attached to a bottom face, a material different from the material of the heat receiving member can be combined, or a plate material of a thickness that cannot be realized by die casting and extruding can be also used, and the degree of freedom of design is increased.

The heat receiving structure : includes a heat receiving plate that is thermally coupled to a heating element, on heat receiving faces of the heat receiving members.

The heat receiving plate may be made of copper or a copper alloy.

In the above configurations, heat conductivity is enhanced.

The heat receiving members may be made of aluminum or an aluminum alloy.

According to the configuration, the heat receiving members can be produced by a working method at low cost such as extruding and die casting.

The heat receiving members are divided in a radial direction of the heat pipe.

Further, the present invention may be a heat sink including the heat receiving structure according to any one of claims 1 to 5, in a heat receiving section.

### Advantageous Effects of Invention

In the present invention, the heat obtained from the heat receiving face also can be inputted into the heat pipe from the side faces, and heat performance is improved. Further, by attaching the heat receiving members at both sides to the heating section, the heat pipe has the structure held by the heat receiving members at both sides, and therefore the heat pipe can be fixed at low cost without using brazing and soldering with high working cost and an adhesive with low heat performance. Further, in the case of combined use with brazing and soldering, or the like, strength is increased with respect to the ripping forces from the heat receiving face.

Further, at the time of producing the heat receiving members, a working method with low cost such as extruding and die casting can be used, and at the time of producing the heat receiving members by cutting work, only the shapes corresponding to the side face portions of the pipe have to be worked, and therefore the cutting work time can be reduced.

### Brief Description of Drawings

[Figure 1] Figure 1 is a view showing an example of a heat receiving structure not within the scope of the invention.
[Figure 2] Figure 2 is a sectional view taken along II to II in Figure 1.
[Figure 3] Figure 3 is a sectional view of a heat receiving section of another example not within the scope of the invention.
[Figure 4] Figure 4 is a sectional view of a heat receiving section in another example not within the scope of the invention.
[Figure 5] Figure 5 is a sectional view of a heat receiving section in another example not within the scope of the invention.
[Figure 6] Figure 6 is a sectional view of a heat receiving section in another example not within the scope of the invention.
[Figure 7] Figure 7 is a sectional view of a heat receiving section in another example not within the scope of the invention.
[Figure 8] Figure 8 is a sectional view of a heat receiving section in another example not within the scope of the invention.
[Figure 9] Figure 9 is a sectional view of a heat receiving section in another example not within the scope of the invention.
[Figure 10] Figure 10 is a sectional view of a heat receiving section in another example not within the scope of the invention.
[Figure 11] Figure 11 is a perspective view showing a heat receiving member in Figure 10.
[Figure 12] Figure 12 is a view equivalent to Figure 10, showing a heat receiving section of another example not within the scope of the invention.
[Figure 13] Figure 13 is a sectional view of a heat receiving section in an embodiment of the invention.
[Figure 14] Figure 14 is a sectional view of a heat receiving section in another embodiment.
[Figure 15] Figure 15 is a sectional view of a heat receiving section in another example not within the scope of the invention.
[Figure 16] Figure 16 is a sectional view of a heat receiving section in another example not within the scope of the invention.
[Figure 17] Figure 17 is a sectional view of a heat receiving section in another embodiment.
[Figure 18] Figure 18 is a sectional view of a heat receiving section in another embodiment.
[Figure 19] Figure 19 is a perspective view showing a comparative example in which thermal analysis is performed.
[Figure 20] Figure 20 is a perspective view showing a mode in which thermal analysis is performed.
[Figure 21] Figure 21 is a perspective view showing another mode in which thermal analysis is performed.
[Figure 22] Figure 22 is a perspective view showing another mode in which thermal analysis is performed.
[Figure 23] Figure 23 is a table showing an experimental result of performing thermal analysis.

### Description of Embodiments

Hereinafter, an embodiment of the invention will be described with the drawings.

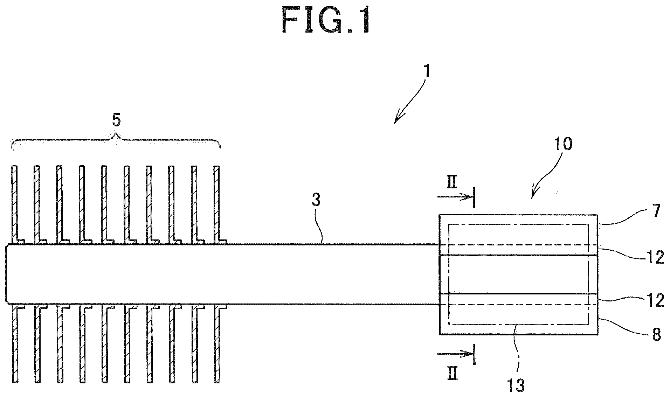

Figure 1 is a view showing an example not within the scope of the invention.

Reference sign 1 denotes a heat sink. The heat sink 1 is configured by a heat pipe 3, a plurality of radiation fins 5 provided at a heat radiation section of the heat pipe, and heat receiving structure 10 provided at a heat receiving section of the heat pipe 3.

The above described heat pipe 3 is what is made by sealing a hydraulic fluid into a pipe formed from a material with high heat conductivity, and transfers heat by generating a cycle of evaporation of the hydraulic fluid (absorption of latent heat), and condensation of the hydraulic fluid (release of the latent heat). For example, when the heat pipe 3 is made of copper, water, methanol, ethanol or the like is selected as the hydraulic fluid.

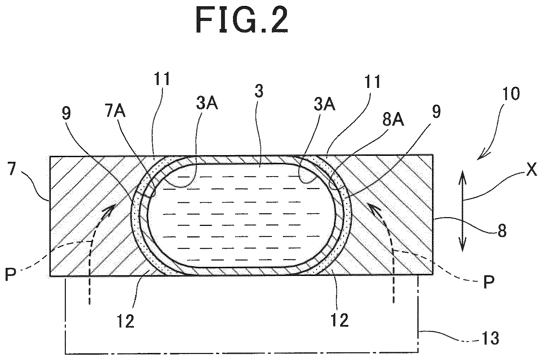

As shown in Figure 2, the heat receiving structure 10 of the heat pipe 3 is configured by sandwiching the heat pipe 3 by a pair of heat receiving blocks (heat receiving members) 7 and 8 from both sides in a longitudinal direction. Between the heat pipe 3, and the respective heat receiving blocks 7 and 8, a brazing and soldering material 9 excellent in heat conductivity is provided. The heat receiving blocks 7 and 8 are made of aluminum or an aluminum alloy, and are easily produced by extruding, die casting or the like.

The heat pipe 3 has a section in an elliptic shape (shape connecting parallel lines with circular arcs). The heat receiving blocks 7 and 8 are disposed to be laterally symmetrical in the drawing, and have the same structures. The heat receiving blocks 7 and 8 have curved concave inner faces 7A and 8A that are along a curved face of an external shape 3A of the heat pipe 3 in close contact with the curved face. In the present configuration, extended portions 11 and 12 at both sides that extend continuously to the inner faces 7A and 8A both extend inward in a long diameter direction of the heat pipe 3 while covering the heat pipe 3. Outer edges of the extended portions 11 and 12 and longitudinal side edges of the heat pipe 3 are flush with one another, and configure the heat receiving section of the heat pipe 3. A heating element 13 is provided by being pasted onto the heat receiving section of the heat pipe 3.

At a time of producing the heat receiving structure 10, the brazing and soldering material 9 is disposed on either one of the heat receiving section of the heat pipe 3, or the inner faces 7A and 8A of the heat receiving blocks 7 and 8, or both of them.

Subsequently, the inner faces 7A and 8A of the heat receiving blocks 7 and 8 are caused to abut on the external shape 3A of the heat pipe 3 from both sides, and are heated under predetermined conditions, whereby the heat receiving blocks 7 and 8 and the heat pipe 3 are brazed and soldered by the brazing and soldering material 9.

According to the example the heat receiving blocks 7 and 8 have the curved concave inner faces 7A and 8A which are along the curved face of the external shape 3A of the heat pipe 3 in close contact with the curved face, and therefore, a sufficient contact area can be ensured between the heat pipe 3, and the heat receiving blocks 7 and 8. Further, heat that is obtained from the heat receiving faces of the heat receiving blocks 7 and 8 also can be inputted into the heat pipe 3 from the side faces as shown by arrows P of broken lines in Figure 2. Accordingly, heat performance is improved. Further, since the heat pipe 3 is held by the extended portions 11 and 12 provided in the heat receiving blocks 7 and 8, strength is increased with respect to ripping forces in two directions (arrow X) from the heat receiving face in a case of combined use with brazing and soldering, or the like.

By attaching the heat receiving blocks 7 and 8 at both sides to a heating section, the heat pipe 3 has a structure held by the heat receiving blocks 7 and 8 at both sides, and therefore, the heat pipe 3 can be fixed at low cost without using brazing and soldering with high working cost, and an adhesive with low heat performance.

At the time of producing the heat receiving blocks 7 and 8, a working method with low cost such as extruding and die casting can be used, for example, and when the heat receiving blocks 7 and 8 are produced by cutting work due to limitation of the material, only the shapes corresponding to the side face portions of the heat pipe 3 have to be worked, so that a cutting work time can be reduced.

For example, when a heat receiving plate is attached to a bottom face, a material different from the material of the block can be combined, or a plate material of a thickness and a profile irregularity (flatness, surface roughness, and the like) that cannot be realized by die casting and extruding can be also used, and the degree of freedom of design is increased.

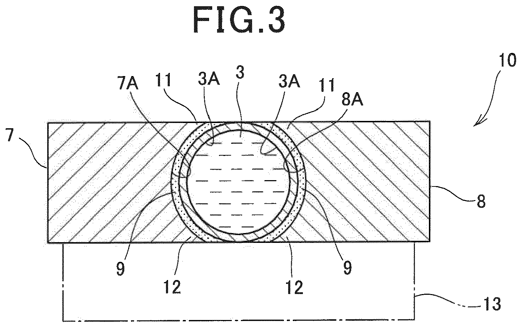

Figure 3 shows another example not within the scope of the invention. Note that the same parts as those in Figure 2 are assigned with the same reference signs, and explanation will be omitted.

The heat pipe 3 is circular in section. The heat receiving blocks 7 and 8 are disposed to be laterally symmetrical in the drawing, and have the same structures. The heat receiving blocks 7 and 8 have circular-arc concave inner faces 7A and 8A that are along a curved face of the external shape 3A of the heat pipe 3 in close contact with the curved face.

In the present configuration, the extended portions 11 and 12 at both sides which extend continuously to the inner faces 7A and 8A both extend inward in a diameter direction of the heat pipe 3 while covering the heat pipe 3. Reference sign 13 denotes a heating element that is disposed in the heat receiving section of the heat pipe 3.

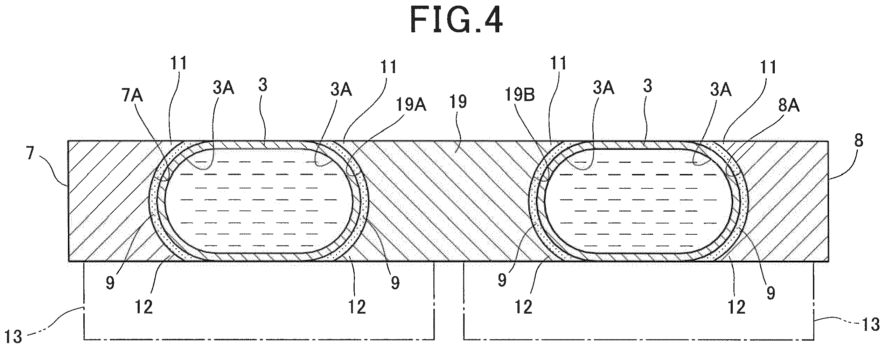

Figure 4 shows another example not within the scope of the invention. Note that the same parts as those in Figure 2 are assigned with the same reference signs, and explanation will be omitted.

A plurality of heat pipes 3 having sections in elliptic shapes line up side by side in a longitudinal direction, and the heat pipes lining up side by side are sandwiched by a plurality of heat receiving blocks 7, 19 and 8.

The heat receiving blocks 7 and 8 at both sides have similar configurations to the heat receiving blocks of the above described example, and the heat receiving block 19 in a central portion has curved concave inner faces 19A and 19B that are along curved faces of the external shapes 3A of the heat pipes 3 in close contact with the curved faces respectively at both end portions.

In the present configuration, in all of the heat receiving blocks 7, 19 and 8, the extended portions 11 and 12 at both sides which extend continuously to the respective inner faces 7A, 8A, 19A and 19B all extend inward in the long diameter directions of the heat pipes 3 while covering the heat pipes 3. Reference sign 13 denotes heating elements that are disposed in the heat receiving sections of the heat pipes 3.

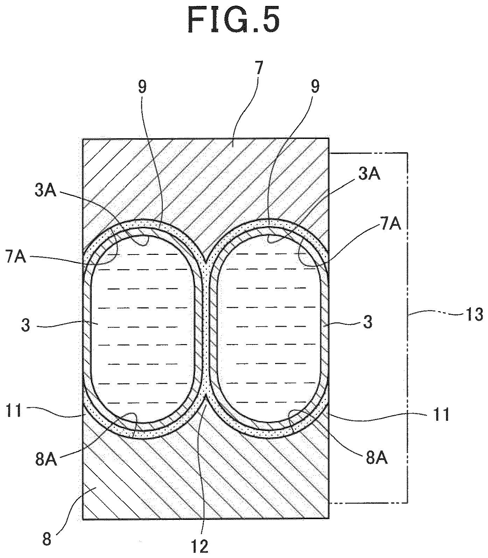

Figure 5 to Figure 7 respectively show other examples not within the scope of the invention. Note that the same parts as those in Figure 2 are assigned with the same reference signs, and explanation will be omitted.

A plurality of heat pipes 3 having sections in elliptic shapes are disposed side by side in a short side direction, and the heat pipes which are disposed side by side are sandwiched by a plurality of heat receiving blocks 7 to 9.

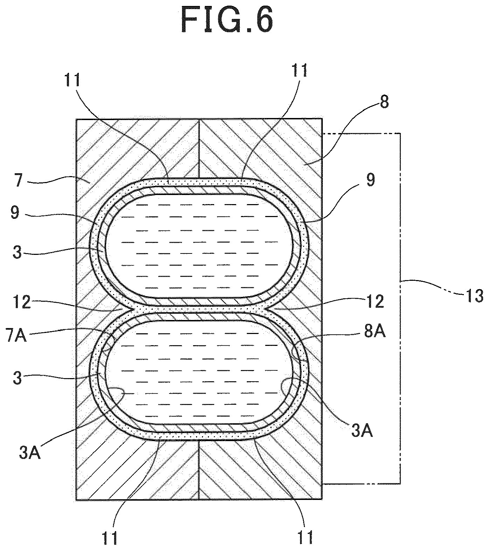

In each of the examples in Figure 5 and Figure 6, the two heat pipes 3 are sandwiched by the two heat receiving blocks 7 and 8 from both sides in the longitudinal direction. The heat receiving blocks 7 and 8 have circular-arc concave inner faces 7A and 8A that are along curved faces of the external shapes 3A of the heat pipes 3 in close contact with the curved faces.

In the present configuration, the extended portions 11 and 12 at both sides which extend continuously to the inner faces 7A and 8A both extend inward in the diameter directions of the heat pipes 3 while covering the heat pipes 3. Reference sign 13 denotes a heating element that is disposed in the heat receiving section of the heat pipe 3.

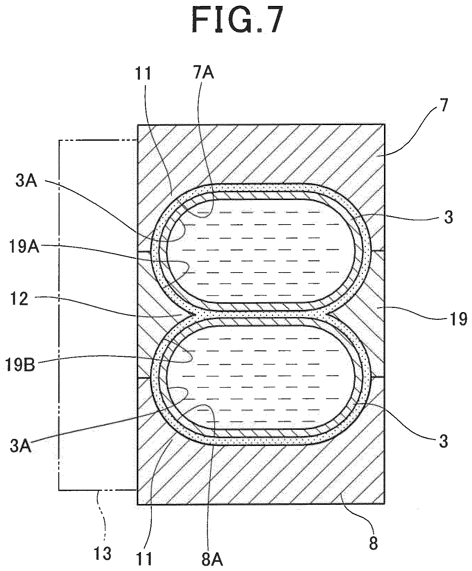

In the mode in Figure 7, two heat pipes 3 are sandwiched by three heat receiving blocks 7, 19 and 8 from both sides in a short side direction. The heat receiving blocks 7, 19 and 8 are divided into three in radial directions of the heat pipes 3 by dividing lines L1 and L2 that are along the longitudinal direction. The heat receiving blocks 7 and 8 at both sides are in close contact with longitudinal one side edges of the heat pipes 3.

In the present configuration, in all of the heat receiving blocks 7, 19 and 8, the extended portions 11 and 12 at both sides which extend continuously to the respective inner faces 7A, 8A, 19A and 19B both extend inward in the long diameter direction of the heat pipes 3 while covering the heat pipes 3. Reference sign 13 denotes a heating element that is disposed in the heat receiving sections of the heat pipes 3.

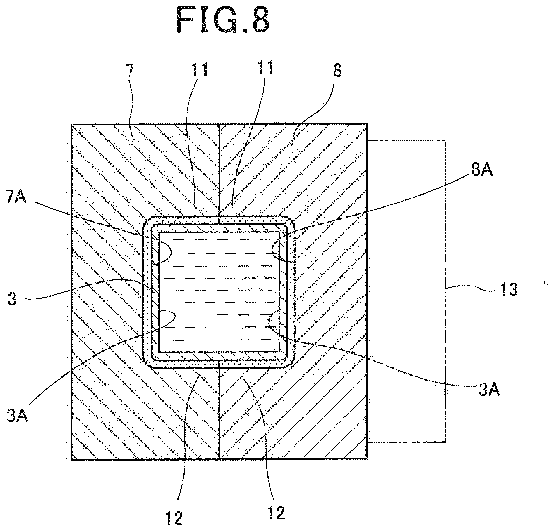

Figure 8 shows another example not within the scope of the invention. Note that the same parts as those in Figure 2 are assigned with the same reference signs, and explanation will be omitted.

The heat pipe 3 has a section in a rectangular shape. The heat receiving blocks 7 and 8 are disposed to be laterally symmetrical in the drawing, and have the same structures. The heat receiving blocks 7 and 8 have concave inner faces 7A and 8A that are along the rectangular shape of the external shape 3A of the heat pipe 3 in close contact with the rectangular shape.

In the present configuration, the extended portions 11 and 12 at both sides which extend continuously to the inner faces 7A and 8A both extend inward in a diameter direction of the heat pipe 3 while covering the heat pipe 3. Reference sign 13 denotes a heating element that is disposed in the heat receiving section of the heat pipe 3.

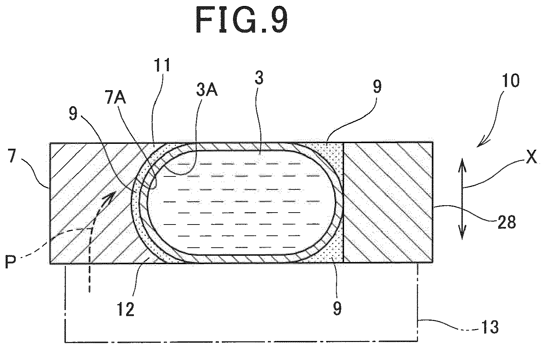

Figure 9 shows another example not within the scope of the invention. Note that the same parts as those in Figure 2 are assigned with the same reference signs, and explanation will be omitted.

In the above described example in Figure 2, each of the heat receiving blocks 7 and 8 includes the extended portions 11 and 12. However, the present invention is not limited to this, and as shown in Figure 9, a configuration can be adopted, in which only the heat receiving block 7 at one side includes the extended portions 11 and 12, and a heat receiving block 28 at the other side does not include the extended portions 11 and 12. The heat receiving block 28 at the other side is rectangular in section. In the heat receiving block 28, an inner face 28A is flat. The flat inner face 28A abuts on the external shape 3A of the heat pipe 3, and the heat pipe 3 and the heat receiving block 28 are joined by the brazing and soldering material 9.

In the present example, the heat pipe 3 is held by the extended portions 11 and 12 which are provided in the heat receiving block 7 at the one side, and therefore, strength is increased with respect to ripping forces in two directions (arrow X) from the heat receiving face in the case of combined use with brazing and soldering, or the like.

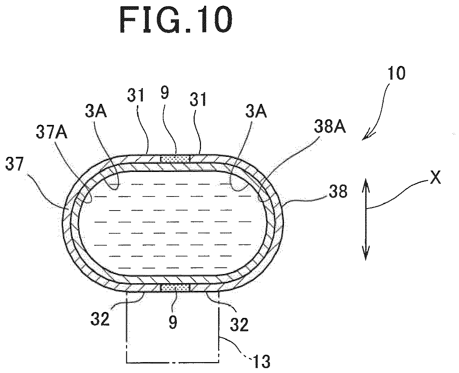

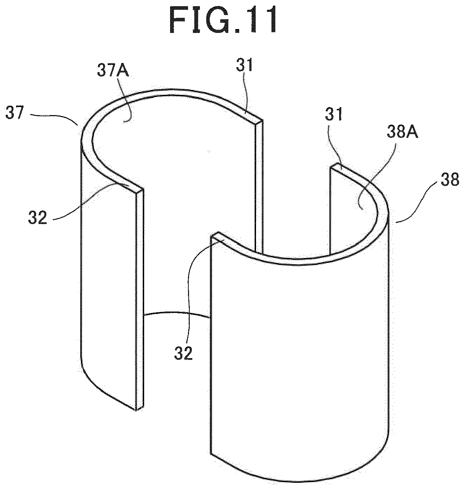

Figure 10 and Figure 11 show other examples not within the scope of the invention. Note that the same parts as those in Figure 2 are assigned with the same reference signs, and explanation will be omitted.

As shown in Figure 10 and Figure 11, a heat receiving member according to the example is configured by a pair of curved plate members 37 and 38 that are formed by curving a plate material. Inner faces 37A and 38A of the curved plate members 37 and 38 are in shapes along the external shape 3A of the heat pipe 3. Extended portions 31 and 32 at both sides that extend continuously to the inner faces 37A and 38B both extend inward in the long diameter direction of the heat pipe 3 while covering the heat pipe 3. Outer edges of the extended portions 31 and 32, and longitudinal side edges of the heat pipe 3 are flush with one another via the brazing and soldering material 9, and configure the heat receiving section of the heat pipe 3. The heating element 13 is provided by being pasted on the heat receiving section of the heat pipe 3.

In the example, the heat pipe 3 is held by the extended portions 31 and 32 which are provided in the curved plate members 37 and 38, and therefore, strength is increased with respect to ripping forces in two directions (arrow X) from the heat receiving face in the case of combined use with brazing and soldering, or the like.

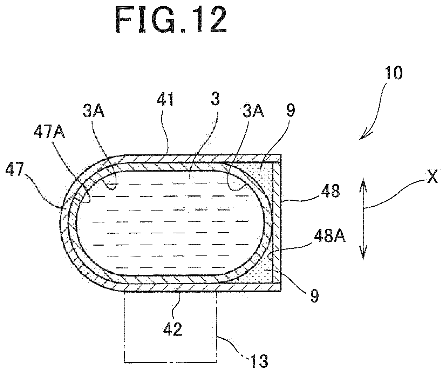

Figure 12 shows another example not within the scope of the invention. Note that the same parts as those in Figure 2 are assigned with the same reference signs, and explanation will be omitted.

In this example, a heat receiving member at one side is configured by a curved plate member 47, and a heat receiving member at the other side is configured by a flat plate member 48. The curved plate member 47 includes a concave inner face 47A that is along the external shape 3A of the heat pipe 3. Extended portions 41 and 42 that extend while covering the heat pipe 3 continue to both sides of the inner face 47A.

The extended portions 41 and 42 extend in the longitudinal direction of the heat pipe 3 beyond a long diameter of the heat pipe 3. In the plate member 48, an inner face 48A is flat. The flat inner face 48A abuts on the external shape 3A of the heat pipe 3, and the heat pipe 3, the extended portions 41 and 42 and the plate member 48 are joined by the brazing and soldering material 9.

In the present example, the heat pipe 3 is held by the extended portions 41 and 42 provided in the curved plate member 47 at the one side, and therefore, strength is increased with respect to ripping forces in two directions (arrow X) from the heat receiving face in the case of combined use with brazing and soldering, or the like.

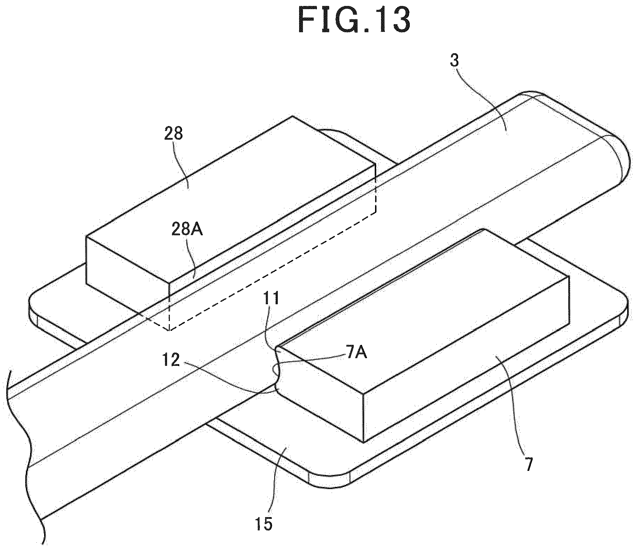

Figure 13 shows an embodiment of the invention. Note that the same parts as those in Figure 9 are assigned with the same reference signs, and explanation will be omitted.

In this embodiment, only the heat receiving block 7 at one side includes the extended portions 11 and 12, and a heat receiving block 28 at the other side is rectangular in section in the same way as the configuration in Figure 9. On heat receiving faces of the heat receiving blocks 7 and 28, a heat receiving plate 15 that is thermally connected to a heating element (not illustrated) is provided across the heat pipe 3, and the heat receiving blocks 7 and 28.

The heat receiving blocks 7 and 28 are desirably made of aluminum or an aluminum alloy, and the heat receiving plate 15 is desirably made of copper or a copper alloy excellent in heat conductivity.

In this configuration, the heat receiving blocks 7 and 28 can be produced at low cost by extruding, die casting or the like, and if the heat receiving plate 15 is made of copper or a copper alloy excellent in heat conductivity, heat performance can be enhanced.

Note that in the present embodiment, only the heat receiving block 7 at one side includes the extended portions 11 and 12, and the heat receiving block 28 at the other side is made rectangular in section, but both of the heat receiving blocks may include extended portions. In this case, a configuration is such that a heat receiving plate is provided in the example shown in Figure 1.

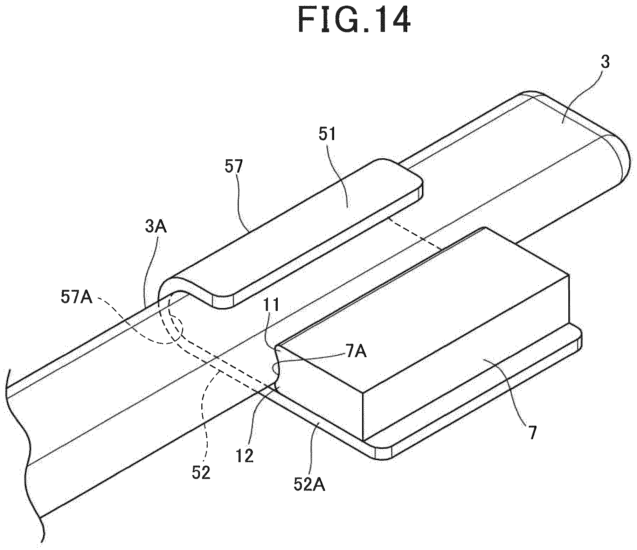

Figure 14 shows another embodiment. Note that the same parts as those in Figure 13 are assigned with the same reference signs, and explanation will be omitted.

In this embodiment, a heat receiving member at one side is configured by a curved plate member 57 formed by curving a plate material. An inner face 57A of the curved plate member 57 is in a shape along the external shape 3A of the heat pipe 3. Extended portions 51 and 52 continue to the inner face 57A. The extended portion 51 at one side extends inward in the long diameter direction of the heat pipe 3 while covering an upper portion in the drawing of the heat pipe 3, and terminates at a substantially central portion in the long diameter of the heat pipe 3.

The extended portion 52 at the other side extends inward in the long diameter direction of the heat pipe 3 while covering a lower portion in the drawing of the heat pipe 3, and on an overhang portion 52A of the extended portion 52, the heat receiving block 7 is disposed similarly to Figure 13. The heat pipe 3 is sandwiched between the heat receiving block 7 and the curved plate member 57, and is joined thereto via a brazing and soldering material.

In the present embodiment, the heat pipe 3 is held by the curved plate member 57, and the extended portions 51, 52, 11 and 12 which are provided in the heat receiving block 7, and therefore, strength is increased with respect to ripping forces from the heat receiving face in the case of combined use with brazing and soldering, or the like.

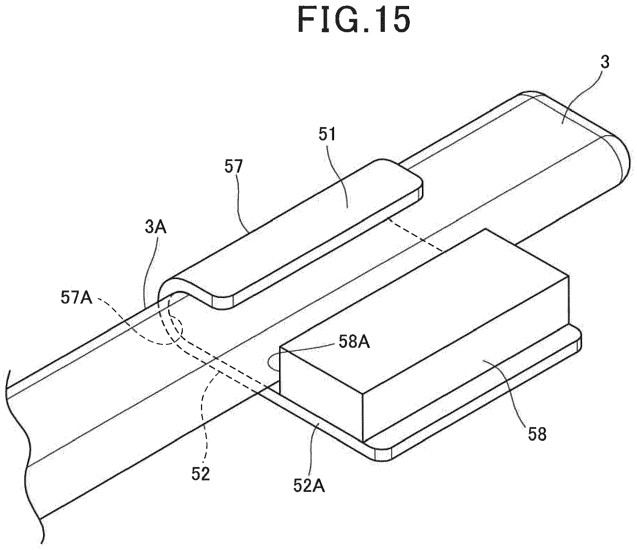

Figure 15 shows another example not within the scope of the invention. Note that the same parts as those in Figure 14 are assigned with the same reference signs, and explanation will be omitted.

In this example, the heat pipe 3 is configured by being sandwiched by the curved plate member 57 and a heat receiving block 58 from both sides. The heat receiving block 58 is rectangular in section.

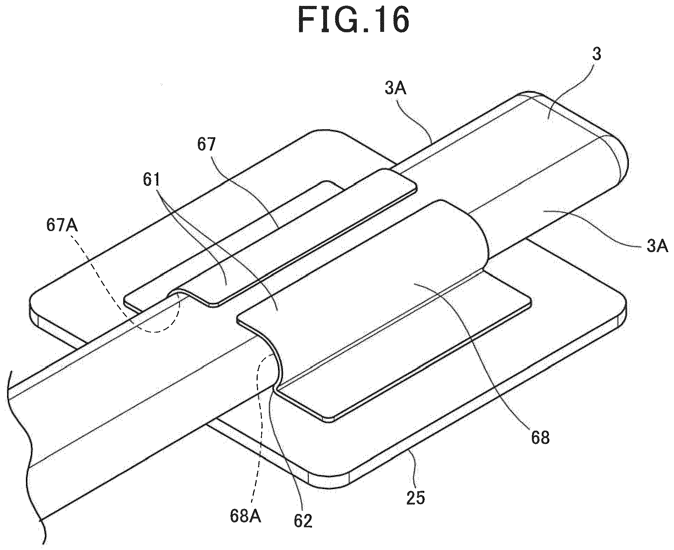

Figure 16 shows another example not within the scope of the invention.

In this example a heat receiving structure is configured by a heat receiving plate 25, and a pair of curved plate members 67 and 68 that are brazed and soldered to the heat receiving plate 25.

The curved plate members 67 and 68 are configured by curving a plate material. Inner faces 67A and 68A of the curved plate members 67 and 68 are in shapes along the external shape 3A of the heat pipe 3. Extended portions 61 and 62 continue to the inner faces 67A and 68A. The extended portion 61 at one side extends inward in the long diameter direction of the heat pipe 3 while covering an upper portion in the drawing of the heat pipe 3, and terminates at a substantially central portion in the long diameter of the heat pipe 3. The extended portion 62 at the other side extends while covering a lower portion in the drawing of the heat pipe 3 in cooperation with the heat receiving plate 25.

In the present example, the heat pipe 3 is held by the extended portions 61 and 62 which are provided in the curved plate members 67 and 68, and therefore, strength is increased with respect to ripping forces for the heat pipe 3 from the heat receiving face in the case of combined use with brazing and soldering, or the like.

In the example a pair of curved plate members 67 and 68 are brazed and soldered to the heat receiving plate 25. However, a pair of curved plate members 67 and 68 may be brazed and soldered to a heating element (not illustrated) itself, without adopting the heat receiving plate 25.

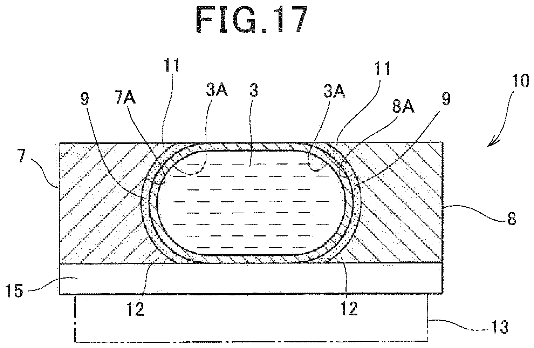

Figure 17 shows another embodiment. Note that the same parts as those in Figure 2 are assigned with the same reference signs, and explanation will be omitted.

In this mode, in the heat receiving structure 10, on heat receiving faces of the heat receiving blocks 7 and 8, the heat receiving plate 15 that is thermally coupled to the heating element 13 is provided, across longitudinal one side edges of the heat pipe 3, and the heat receiving blocks 7 and 8.

The heat receiving blocks 7 and 8 are desirably made of aluminum or an aluminum alloy, and the heat receiving plate 15 is desirably made of copper or a copper alloy excellent in heat conductivity.

In this configuration, the heat receiving blocks 7 and 8 can be produced at low cost by extruding, die casting or the like, and if the heat receiving plate 15 is made of copper or a copper alloy excellent in heat conductivity, heat performance can be enhanced.

The heat receiving plate 15 is preferably provided on the heat receiving faces of the heat receiving blocks 7 and 8 in all of the modes such as the heat receiving structures 10 of the modes in Figure 3 to Figure 8 though not illustrated, without being limited to the heat receiving structure 10 of the mode in Figure 2. Further, the heat receiving plate 15 and the heat receiving blocks 7 and 8 are formed from different kinds of metals, but may be formed from the same kind of metal. For example, all of them may be produced from aluminum, an aluminum alloy or the like.

With the heat sink 1 including the aforementioned heat receiving structure 10 in the heat receiving section, the aforementioned favorable effects can be obtained, irrespective of the mode of the heat radiation section.

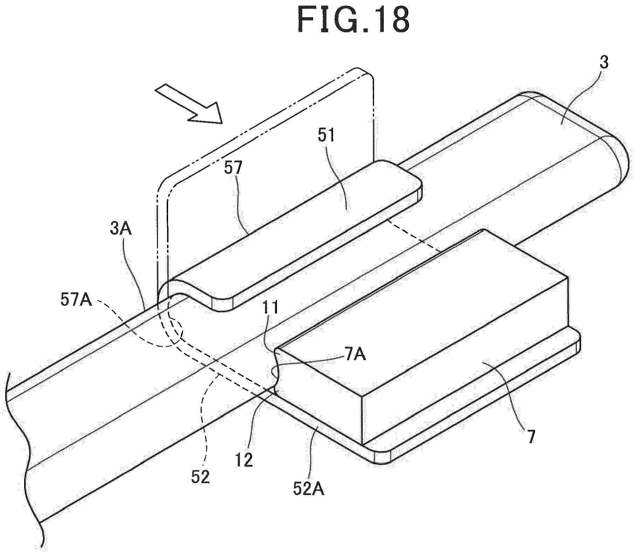

Figure 18 shows another embodiment. Note that the same parts as those in Figure 14 are assigned with the same reference signs, and explanation will be omitted.

In this embodiment, a heat receiving member at one side is configured by the curved plate member 57 which is formed by curving a plate material. In the curved plate member 57, the extended portion 51 at one side is raised in advance as shown by a phantom line. Subsequently, after the heat pipe 3 is sandwiched between the curved plate member 57 and the heat receiving block 7, the extended portion 51 at one side is folded as shown by the solid line, and the embodiment shown in Figure 14 can be realized at a time of completion of assembly.

Further, with respect to the example shown in Figure 15, the extended portion 51 at one side is raised (not illustrated) in advance, and after the heat pipe 3 is sandwiched between the extended portion 51 and the heat receiving block 58, the extended portion 51 at one side is folded, in the same way, whereby the example shown in Figure 15 can be realized at a time of completion of assembly. Furthermore, with respect to the example shown in Figure 16, the curved plate members 67 and 68 are raised in advance, and after the heat pipe 3 is disposed, the pair of extended portions 61 are folded, in the same way, whereby the example shown in Figure 16 can be realized at a time of completion of assembly.

By this configuration, strength is also enhanced with respect to the ripping forces from the heat receiving surface.

The present invention is described thus far on the basis of an embodiment, but it is obvious that the present invention is not limited to the embodiment.

Referring to each of Figure 13 and Figure 14, for example, the extended portion 11 at the upper side of the heat receiving block 7 at one side is raised in advance, and after the heat pipe 3 is attached, the extended portion 11 at the upper side is deformed by crimping, whereby the present embodiment can be realized at a time of completion of assembly. Further, in Figure 16, the extended portions 61 are raised in advance, and after the heat pipe 3 is attached, the extended portions 61 at the upper sides are deformed by crimping, whereby the present example can be realized at a time of completion of assembly. In Figure 16, the heat receiving plate 25 and the pair of curved plate members 67 and 68 are brazed and soldered. Without being limited to brazing and soldering, for example, the heat receiving plate 25 and the pair of curved plate members 67 and 68 are integrally structured in advance, the extended portions 61 are raised in advance, and after the heat pipe 3 is attached, the extended portions 61 at the upper sides are deformed by crimping, whereby the present embodiment can be realized at a time of completion of assembly.

Next, an example of the present invention will be described.

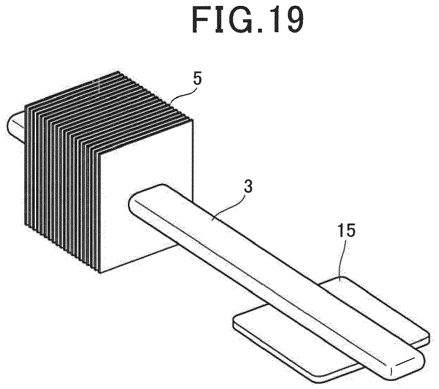

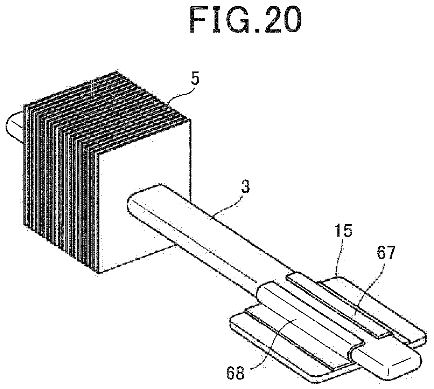

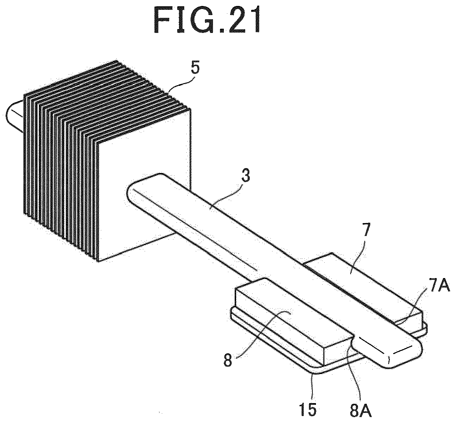

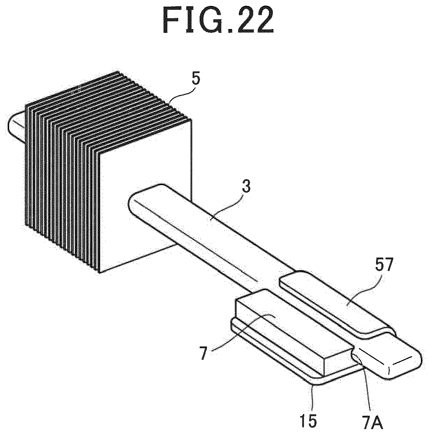

Figure 19 shows a mode in which only the heat receiving plate 15 is provided at the heat pipe 3, and shows a comparative example to which the present invention is not applied. Figure 20 shows a mode in which the pair of curved plate members 67 and 68 are provided in the heat receiving plate 15, and is similar to the mode shown in Figure 16. Figure 21 shows a mode in which a pair of heat receiving blocks 7 and 8 having the curved concave inner faces 7A and 8A are disposed at both sides of the heat pipe 3, and the heat receiving plate 15 is disposed across the heat pipe 3 and the heat receiving blocks 7 and 8. Figure 22 shows a mode in which the heat receiving blocks 7 and 8 are provided at one side, and the curved plate member 57 formed by curving a plate material is provided at the other side, and is similar to the mode shown in Figure 14.

To the heat receiving plates 15 of the respective heat sinks 1 shown in Figure 19 to Figure 22, dummy elements each formed by attaching a ceramics heater to a copper heater block for measurement were attached, and air was blown to the fins 5 to keep the temperature of the heat pipe 3 at 70°C. A thermocouple was inserted into a hole formed in a central portion of a side face of each of the heater blocks, and an internal temperature of each of the heater blocks was measured.

A size of the dummy element was 20 mm by 20 mm, a heating value of the dummy element was 30 W, a size of the heat receiving plate 15 was 30 mm by 30 mm by 1 mm, a thickness of each of the curved plate members was 0.3 mm, a thickness of each of the heat receiving blocks 7 and 8 was 4 mm, the heat receiving blocks 7 and 8 were made of aluminum, and the heat receiving plate 15 was made of copper. Further, a size of the single fin 5 was 30 mm by 30 mm, the number of fins 5 was 20, a pitch of the respective fins 5 was 1.5 mm, and a material of the fin 5 was aluminum.

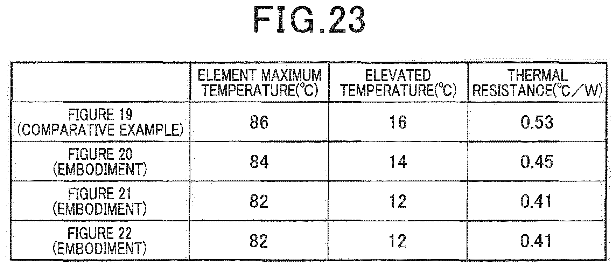

An experimental result of measuring the internal temperatures of the heater blocks under the above conditions is shown in Figure 23.

It is generally known that if the heater block or the like is installed on the heat receiving plate 15, the temperature rises because the thermal resistance is added.

According to the experimental result, it is found out that as compared with the comparative example shown in Figure 19, an elevated temperature in each of the embodiments can be reduced more, and thermal resistance can be reduced more.

More specifically, it is found out that in the comparative example shown in Figure 19, the temperature of the heater block rises to 86°C, and large thermal resistance is added.

In contrast with this, it is found out that in the mode shown in Figure 20, the temperature rise can be restrained to 84°C, and in the modes shown in Figure 21 and Figure 22, the temperature rise can be restrained to 82°C. As a result, it is found out that in the comparative example shown in Figure 19, the thermal resistance is 0.53°C/W, whereas in the modes shown in Figure 20 to Figure 22, the thermal resistance is 0.41 to 0.45°C/W, and by adopting the configuration as in the present embodiment, heat resistance can be reduced while heat performance is enhanced.

### Reference Signs List

- 1: Heat sink
- 3: Heat pipe
- 5: Radiation fin
- 7, 8, 19, 28, 58: Heat receiving block (heat receiving member)
- 7A, 8A, 9A, 9B: Inner face
- 10: Heat receiving structure
- 11, 12, 51, 52, 61, 62: Extended portion
- 13: Heating element
- 15: Heat receiving plate
- 37, 38: Curved plate member (heat receiving member)

## Claims

1. A heat receiving structure (10) comprising:
a heat pipe (3) sandwiched by heat receiving members (7, 8, 28) from the left side and the right side of the heat pipe (3), and the heat pipe (3) joined to the heat receiving members (7, 8, 28); wherein
a heat receiving plate (15) that is connected to heat receiving faces of the heat receiving members (7, 8, 28) and the heat pipe (3) contacts with both, the left and right heat receiving members (7, 8, 28) and the heat pipe (3), elements of the left and right heat receiving members (7, 8, 28) and the heat pipe (3) being disposed on the heat receiving plate (15), and a heating element (13) is arranged so that it is thermally coupled to said heat receiving plate (15),
wherein at least one of the heat receiving members (7, 8) at the respective left or right side face of the heat pipe (3) includes a concave inner face (7A, 8A) that is along an external shape (3A) of the heat pipe (3),
wherein the concave inner face (7A, 8A) of the at least one heat receiving member (7, 8) defines extended portions (11, 12) and **characterized in that** the extended portions (11, 12) extend parallel to the surface of the heat receiving plate (15) and along the external shape (3A) of the heat pipe (3) while covering the heat pipe (3),
wherein the heat receiving plate (15), the heating element (13) and the heat receiving members (7, 8, 28) are provided as separate parts,
wherein the extended portions (11, 12) of the at least one heat receiving member (7, 8) are arranged to conduct the heat received from the heat receiving plate (15) into the left or right side of the side face of the heat pipe (3), and
wherein the heat receiving members (7, 8, 28) have a block shape.

2. The heat receiving structure (10) according to claim 1,
wherein the heat receiving plate (15) is made of copper or a copper alloy.

3. The heat receiving structure (10) according to claim 1 or 2,
wherein the heat receiving members (7, 8, 28) are made of aluminum or an aluminum alloy.

4. The heat receiving structure (10) according to claim 1, 2 or 3,
wherein the heat receiving plate (15) is disposed across the heat pipe (3) and the heat receiving members (7, 8, 28) in a longitudinal direction on one side of said heat pipe (3) and heat receiving members (7, 8, 28).

5. The heat receiving structure (10) according to claim 1, 2, 3 or 4,
wherein the heat receiving members (7, 8, 28) are divided in a radial direction of the heat pipe (3).

6. A heat sink (1), comprising: the heat receiving structure (10) according to claim 1, 2, 3, 4 or 5, in a heat receiving section.

## Patentansprüche

1. Wärmeaufnahmestruktur (10), umfassend:
ein Wärmerohr (3) das von Wärmeaufnahmeelementen (7, 8, 28) von der linken Seite und der rechten Seite des Wärmerohrs (3) eingefasst ist, wobei das Wärmerohr (3), mit den Wärmeaufnahmeelementen (7, 8, 28) verbunden ist; wobei
eine Wärmeaufnahmeplatte (15), die mit den Wärmeaufnahmeflächen der Wärmeaufnahmeelemente (7, 8, 28) und dem Wärmerohr (3) verbunden ist, sowohl das linke als auch das rechte Wärmeaufnahmeelement (7, 8, 28) und das Wärmerohr (3) berührt, wobei Elemente der linken und rechten Wärmeaufnahmeelemente (7, 8, 28) und des Wärmerohrs (3) auf der Wärmeaufnahmeplatte (15) angeordnet sind, und ein Heizelement (13) so angeordnet ist, dass es thermisch mit der Wärmeaufnahmeplatte (15) gekoppelt ist,
wobei zumindest ein Wärmeaufnahmeelement (7, 8) an der jeweiligen linken oder rechten Seitenfläche des Wärmerohrs (3) eine konkave Innenfläche (7a, 8a) aufweist, die sich entlang einer äußeren Form (3A) des Wärmerohrs (3) erstreckt,
wobei die konkave Innenfläche (7A, 8A) des mindestens einen Wärmeaufnahmeelements (7, 8) ausgedehnte Abschnitte (11, 12) definiert, und **dadurch gekennzeichnet, dass** sich die ausgedehnten Abschnitte (11, 12) parallel zu der Oberfläche der Wärmeaufnahmeplatte (15) und entlang der äußeren Form (3A) des Wärmerohrs (3) erstrecken, während sie die Abdeckung des Wärmerohrs (3) bedecken,
wobei die Wärmeaufnahmeplatte (15), das Heizelement (13) und die Wärmeaufnahmeelemente (7, 8, 28) als separate Teile vorgesehen sind,
wobei die ausgedehnten Abschnitte (11, 12) des mindestens einen Wärmeaufnahmeelementes (7, 8) so angeordnet sind, dass sie die von der Wärmeaufnahmeplatte (15) empfangene Wärme in die linke oder rechte Seite der Seitenfläche des Wärmerohrs (3) leiten und
wobei die Wärmeaufnahmeelemente (7, 8, 28) eine Blockform haben.

2. Wärmeaufnahmestruktur (10) nach Anspruch 1, wobei die Wärmeaufnahmeplatte (15) aus Kupfer oder einer Kupferlegierung hergestellt sind.

3. Wärmeaufnahmestruktur (10) nach Anspruch 1 oder 2,
wobei die Wärmeaufnahmeelemente (7, 8, 28) aus Aluminium oder einer Aluminiumlegierung hergestellt sind.

4. Wärmeaufnahmestruktur (10) nach Anspruch 1, 2 oder 3,
wobei die Wärmeaufnahmeplatte (15) über das Wärmerohr (3) und die Wärmeaufnahmeelemente (7, 8, 28) in einer Längsrichtung auf einer Seite des Wärmerohres (3) und der Wärmeaufnahmeelemente (7 8, 28) angeordnet ist.

5. Wärmeaufnahmestruktur (10) nach Anspruch 1, 2, 3 oder 4, wobei die Wärmeaufnahmeelemente (7, 8, 28) in radialer Richtung des Wärmerohrs (3) unterteilt sind.

6. Ein Kühlkörper (1), umfassend: die Wärmeaufnahmestruktur (10) nach Anspruch 1, 2, 3, 4, oder 5, in einem Wärmeaufnahmebereich.

## Revendications

1. Structure de réception de chaleur (10) comprenant :
un caloduc (3) pris en sandwich par des éléments de réception de chaleur (7, 8, 28) du côté gauche et du côté droit du caloduc (3), et le caloduc (3) relié aux éléments de réception de chaleur (7, 8, 28);
où une plaque de réception de chaleur (15) qui est connectée aux faces de réception de chaleur des éléments de réception de chaleur (7, 8, 28) et le caloduc (3) entre en contact avec les deux, les éléments de réception de chaleur gauche et droit (7, 8, 28) et le caloduc (3), les éléments des éléments de réception de chaleur gauche et droit (7, 8, 28) et le caloduc (3) étant disposés sur la plaque de réception de chaleur (15), et un élément chauffant (13) est agencé de manière à être couplé thermiquement à ladite plaque de réception de chaleur (15),
dans laquelle au moins l'un des éléments de réception de chaleur (7, 8) sur la face latérale gauche ou droite respective du caloduc (3) comprend une face intérieure concave (7A, 8A) qui est le long d'une forme externe (3A) de le caloduc (3),
dans laquelle la face intérieure concave (7A, 8A) du au moins un élément de réception de chaleur (7, 8) définit des parties étendues (11, 12) et est **caractérisé en ce que** les parties étendues (11, 12) s'étendre parallèlement à la surface de la plaque de réception de chaleur (15) et le long de la forme externe (3A) du caloduc (3) tout en recouvrant le caloduc (3),
dans laquelle la plaque de réception de chaleur (15), l'élément chauffant (13) et les éléments de réception de chaleur (7, 8, 28) sont fournis en tant que parties distinctes,
dans laquelle les parties étendues (11, 12) du au moins un élément de réception de chaleur (7, 8) sont agencés pour conduire la chaleur reçue de la plaque de réception de chaleur (15) dans le côté gauche ou droite de la face latérale du caloduc (3), et
dans laquelle les éléments récepteurs de chaleur (7, 8, 28) ont une forme de bloc.

2. Structure de réception de chaleur (10) selon la revendication 1, dans laquelle la plaque de réception de chaleur (15) est en cuivre ou en alliage de cuivre.

3. Structure de réception de chaleur (10) selon la revendication 1 ou 2,
dans laquelle les éléments récepteurs de chaleur (7, 8, 28) sont en aluminium ou en alliage d'aluminium.

4. La structure de réception de chaleur (10) selon la revendication 1, 2 ou 3,
dans laquelle, la plaque de réception de chaleur (15) est disposée à travers le caloduc (3) et les éléments de réception de chaleur (7, 8, 28) dans une direction longitudinale sur un côté dudit caloduc (3) et des éléments de réception de chaleur (7, 8, 28).

5. Structure de réception de chaleur (10) selon la revendication 1, 2, 3 ou 4,
dans laquelle les éléments récepteurs de chaleur (7, 8, 28) sont divisés dans une direction radiale du caloduc (3).

6. Dissipateur de chaleur (1), comprenant : la structure de réception de chaleur (10) selon la revendication 1, 2, 3, 4, ou 5, dans une section de réception de chaleur.
